Europäisches Patentamt

European Patent Office

Office européen des brevets

(19)

(11) Veröffentlichungsnummer: **0 182 068**
A2

## (12) EUROPÄISCHE PATENTANMELDUNG

(21) Anmeldenummer: 85112760.5

(22) Anmeldetag: 08.10.85

(51) Int. Cl.⁴: **H 01 G 1/14,** H 01 G 1/035, H 01 G 9/00

(30) Priorität: 08.10.84 DE 3436900
08.10.84 DE 3436898

(43) Veröffentlichungstag der Anmeldung: 28.05.86
Patentblatt 86/22

(84) Benannte Vertragsstaaten: **BE CH DE FR GB IT LI NL SE**

(71) Anmelder: **Roederstein Spezialfabriken für Bauelemente der Elektronik und Kondensatoren der Starkstromtechnik GmbH, Ludmillastrasse 23/25, D-8300 Landshut (DE)**

(72) Erfinder: **Petrick, Paul, Dr., Oberbreitenauerstrasse 3C, D-8300 Landshut (DE)**

(74) Vertreter: **Dipl.-Phys.Dr. Manitz Dipl.-Ing., Dipl.-Wirtsch. Finsterwald Dipl.-Chem.Dr. Heyn Dipl.-Phys. Rotermund Morgan, B.Sc.(Phys), Robert-Koch-Strasse 1, D-8000 München 22 (DE)**

(54) Oberflächenmontagekondensator.

(57) Es wird ein Kondensator beschrieben, der insbesondere zur Oberflächenmontage durch Reflow- oder Schwallbadlötung bestimmt ist. Der Kondensator besteht aus einem mit einer Umhüllung versehenen Kondensatorkörper mit einander gegenüberliegend in Form von Doppelanschlüssen aus der Umhüllung austretenden Anschlußelementen. Die Anschlußelemente bestehen aus Runddrähten, welche bis unmittelbar angrenzend an die Umhüllung zu Flachdrahtabschnitten gequetscht werden. Jeder flachgepreßte Drahtabschnitt wird zumindest mit einer im wesentlichen rechtwinkligen Abknickung versehen.

0182068

## Kondensator

Die Erfindung betrifft einen Kondensator, insbesondere zur Oberflächenmontage durch Reflow- oder Schwallbadlötung, bestehend aus einem mit einer Umhüllung versehenen Kondensatorkörper mit einander gegenüberliegend in Form von Doppelanschlüssen aus der Umhüllung austretenden Anschlußelementen.

Kondensatoren dieser Art sind aus der DE-PS 31 34 617 bekannt. Die Anschlußelemente dieser bekannten Folien-Kondensatoren bestehen aus mit der jeweiligen stirnseitigen Anschlußschicht verlöteten Einzel- oder Doppelstegen, die mit Abstand zum Kondensatorkörper senkrecht zur stirnseitigen Anschlußschicht zum Kondensatorkörper hin abgewinkelt sind, wobei jeder Steg an der Abwinkelungsstelle in eine breite Kontaktfläche übergeht.

Es sind auch Tantal-Kondensatoren sowohl mit zwei Anschlüssen als auch mit mehr als zwei Anschlüssen bekannt; es ist ferner bekannt, solche Tantal-Kondensatoren in Chip-Form auszubilden, so daß mit IC-Gehäusen vergleichbare Elemente vorliegen, die bei Verwendung flacher Kontakte als steckbare Elemente eingesetzt werden können.

Aus dem DE-Gbm 79 24 048 ist es bekannt, den Mittelabschnitt runder Anschlußdrähte flachzupressen und den flachgepreßten Abschnitt dazu zu verwenden, um zwischen aneinandergrenzenden Elementen einen ganz definierten Abstand zu gewährleisten und somit sonst erforderliche Distanzscheiben zu ersetzen.

Aufgabe der Erfindung ist es, Kondensatoren der eingangs definierten Art auf besonders wirtschaftliche Weise mit hoher Maßhaltigkeit herzustellen und ein besonders sicheres automatisches Kontaktieren zu ermöglichen, wobei diese Kondensatoren außerdem gegen die bei der Kontaktierung auftretende Wärmebeaufschlagung unempfindlich sein und optimale elektrische Werte aufweisen müssen.

Gelöst wird diese Aufgabe nach der Erfindung dadurch, daß die Anschlußelemente als Runddrähte ausgebildet sind, daß die über die Umhüllung vorstehenden Runddrahtabschnitte zu Flachdrahtabschnitten gepreßt sind, und daß jeder flachgepreßte Drahtabschnitt zumindest eine im wesentlichen rechtwinklige Abknickung aufweist.

Durch die Verwendung von Runddrähten wird einerseits eine besonders wirtschaftliche Fertigung ermöglicht und andererseits ergeben sich überraschend vorteilhafte elektrische Eigenschaften. Die vorgesehene Umhüllung stellt eine exakte Positionierung der Anschlußelemente sicher, und die nach Ausbildung der Umhüllung hergestellten Flachdrahtabschnitte ermöglichen einerseits eine automatische Bestückung analog zu IC-Gehäusen und schützen andererseits den Kondensatorkörper vor eventuell gefährlicher Wärmebeaufschlagung.

Durch die Verwendung von Runddrähten, die von Rollen ablaufen, gibt es im Gegensatz zu streifenförmigen Anschlußelementen keinerlei Verwindungs- oder Verdrillungsprobleme bei der Fertigung, und der Anlötvorgang kann unproblematisch vor sich gehen. Nach dem Anlöten der Runddrähte an den Kondensatorkörper gibt die jeweilige Kondensatorkörperebene für die Weiterverarbeitung bereits die Quetschebene vor, d.h. es kann exakt ausgerichtet problemfrei gequetscht werden.

Von großem Vorteil ist ferner, daß im Gegensatz zu Runddrähten beim Abbiegen der flachgepreßten Drahtabschnitte keinerlei störenden Kräfte auf den Kondensatorkörper übertragen und damit auch keinerlei Beschädigungen verursacht werden. Bei einem Biegen von Runddrähten in unmittelbarer Nachbarschaft der Umhüllung tritt häufig eine Kraterbildung auf, da das spröde Umhüllungsmaterial platzt und somit schädlicher Feuchtigkeit der Zutritt zum Kondensatorkörper ermöglicht wird.

Dadurch, daß die flachgepreßten Drahtabschnitte sehr nahe am Kondensatorkörper abgebogen werden können, gelangen die flachgequetschten Abschnitte unmittelbar an den Kondensatorkörper heran, wodurch die Induktivität erniedrigt und die Grenzfrequenz höher wird, was zusätzliche Einsatzgebiete für das Bauelement eröffnet.

Im Vergleich zu Anschlußelementen, die aus Blechen gestanzt werden, wird durch die Erfindung auch jeglicher Materialverlust vermieden und der teuere Stanzvorgang überflüssig.

Schließlich ist noch von wesentlicher Bedeutung, daß bei zu Flachdrahtabschnitten gequetschten Runddrähten in den Bereichen, in denen eine Verlötung stattfinden muß, im vollen Umfangsbereich der Anschlußelemente die Verzinnung unverändert bestehen bleibt. Beim Lötvorgang bildet sich dadurch zwischen dem Pad und dem gequetschten Anschlußelement ein exakter und guter Miniskus aus, was zu einer entscheidenden Erhöhung der Zuverlässigkeit der Lötung führt. Bei Stanzteilen aus verzinntem Blech ist demgegenüber an allen Schnittkanten kein Zinn vorhanden, was bei der Verlötung immer wieder zu Schwierigkeiten und Störungen führt.

Besonders vorteilhafte Ausgestaltungen der Erfindung sind in den Unteransprüchen angegeben.

Die Erfindung wird nachfolgend unter Bezugnahme auf die Zeichnung anhand von Ausführungsbeispielen erläutert; in der Zeichnung zeigt:

Fig. 1    eine schematische Darstellung eines Kondensatorkörpers mit stirnseitig angebrachten Runddraht-Anschlußelementen vor der Umhüllung,

Fig. 2    eine schematische Darstellung eines Kondensatorkörpers mit U-förmig gebogenen Anschlußelementen,

Fig. 3    eine Seitenansicht des Kondensators gemäß Fig. 2 nach Umhüllung,

Fig. 4    eine Draufsicht des Kondensators gemäß Fig. 2 nach Umhüllung,

Fig. 5    eine schematische Seitenansicht einer ersten Ausführungsform eines fertigen, zur automatischen Bestückung geeigneten Kondensators nach der Erfindung,

Fig. 6    eine zweite Ausführungsform eines fertigen, zur automatischen Bestückung geeigneten Kondensators nach der Erfindung,

Fig. 7    eine dritte Ausführungsvariante eines fertigen, zur automatischen Bestückung geeigneten Kondensators nach der Erfindung,

Fig. 8 eine schematische Darstellung zur Erläuterung eines besonders vorteilhaften Verfahrens zur Herstellung von Kondensatoren nach der Erfindung,

Fig. 9 eine schematische Darstellung eines Tantalkörpers vor Anbringung der Anschlußelemente und der Umhüllung,

Fig. 10 eine schematische Darstellung des Tantalkörpers nach Fig. 9 mit angebrachten Anschlußelementen,

Fig. 11 eine schematische Darstellung des Kondensators nach Fig. 10 nach erfolgtem Anbringen der Umhüllung,

Fig. 12 eine weitere Ausführungsform eines vier Anschlüsse aufweisenden Tantal-Kondensators vor dem Aufbringen der Umhüllung, und

Fig. 13 eine Seitenansicht des Kondensators nach Fig. 12 nach erfolgtem Anbringen der Umhüllung.

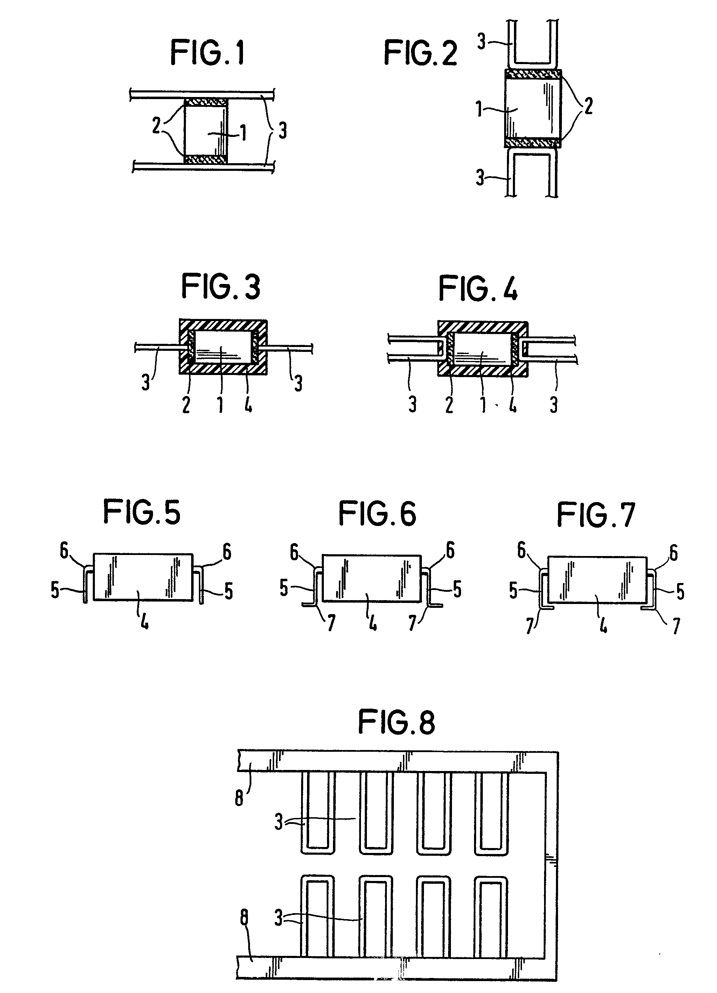

Fig. 1 zeigt in schematischer Weise einen Kondensatorkörper 1, der z.B. aus Aluminium- und Dielektrikumsfolien oder aus metallisierten Folien, insbesondere auch in Schichtbauweise, aufgebaut sein kann. Stirnseitig ist dieser Kondensatorkörper 1 mit Anschlußschichten 2, die bevorzugt durch Schoopieren aufgebracht sind, versehen. Durch Verwendung von vier Drahtanschlüssen, d.h. pro Belag zwei Drahtanschlüssen 3, kann eine in Ausfertigung, Anwendung und bezüglich elektrischer Werte besonders günstige Chip-Bauform bei metallisierten Folien-Kon-

0182068

densatoren erzielt werden.

Fig. 2 zeigt eine der Darstellung in Fig. 1 im wesentlichen entsprechende Ansicht, wobei jedoch als Anschluß-Runddrähte U-förmig gebogene Drahtanschlüsse 3 verwendet sind, und der schmale Mittelteil des U-förmigen Anschlußelements mit der schoopierten Stirnfläche des Kondensators, bei dem es sich bevorzugt um einen metallisierten Folien-Kondensator handelt, elektrisch verbunden ist, und zwar durch Löten oder Schweißen. Die entgegengesetzt parallele Herausführung der Anschlußdrähte 3 aus der auch in Fig. 2 noch nicht gezeigten Umhüllung erweist sich bezüglich Montage und elektrischer Werte besonders vorteilhaft.

Das U-förmige Anschlußelement, das jeder Stirnseite des Kondensators zugeordnet ist, kann symmetrisch, d.h. mit gleichlangen Schenkeln ausgebildet sein, aber es ist auch für manche Anwendungsfälle günstig, den einen Schenkel kürzer als den anderen, insbesondere halb so lang zu wählen.

Die Seitenansicht nach Fig. 3 und die Draufsicht nach Fig. 4 zeigen den anhand von Fig. 2 erläuterten Kondensator nach Anbringung einer Umhüllung 4. Diese Umhüllung 4 besitzt quaderförmige Gestalt und wird bevorzugt durch Umpressen, Umgießen oder durch Einbau des Kondensatorkörpers in einen Becher realisiert. Die Umhüllung besteht insbesondere aus Expoxyd, Polyester oder Silikonharz, und zwar in schwerentflammbarer Einstellung.

Fig. 5 zeigt einen fertigen Kondensator nach der Erfindung, bei dem die Anschluß-Runddrähte unmittelbar nach ihrem Austritt aus der Umhüllung 4 flachgepreßt sind, so daß Flachdrahtabschnitte 5 entstehen. Diese Flachdrahtabschnitte 5 verlaufen in dem Ausführungsbeispiel nach Fig. 5 parallel zu den Seitenflächen der quaderförmigen Umhüllung, da im Bereich des Übergangs vom Runddrahtabschnitt zum Flachdrahtabschnitt eine 90°-Knickstelle 6 vorgesehen ist. Die Anschlußdrähte sind dabei so abgeschnitten, daß sich ein maximaler Überstand von 0,5 mm ergibt.

Bei der Ausführungsform nach Fig. 6 sind die Flachdrahtabschnitte 5 im wesentlichen parallel zu den Stirnwänden des Körpers 4 bis zu dessen unteren Rand geführt und dort nochmals an Knickstellen 7 um 90° nach außen abgebogen.

Bei der Ausführungsvariante nach Fig. 7 sind die freien Endbereiche der Flachdrahtabschnitte 5 nicht nach außen, sondern nach innen um etwa 90° abgebogen und untergreifen den Körper 4 etwas, wobei der freie Endabschnitt der Flachdrahtbereiche wiederum etwa parallel zur Unterseite des Kondensatorkörpers verläuft.

Fig. 8 zeigt eine bevorzugte Möglichkeit zur Herstellung der erfindungsgemäßen Kondensatoren, wobei eine Trägerform mit beidseitigen Rahmenelementen 8 aus Bandmaterial verwendet ist, auf dem nach innen weisend die U-förmigen Anschlußdrähte 3 angeschweißt sind, und zwar mit solchem gegenseitigen Abstand der einander gegenüberliegenden Anschlußdrähte, daß die Kondensatorkörper passend eingefügt und angelötet bzw. angeschweißt werden können, wobei ein kontinuierlicher Fertigungsvorgang möglich ist.

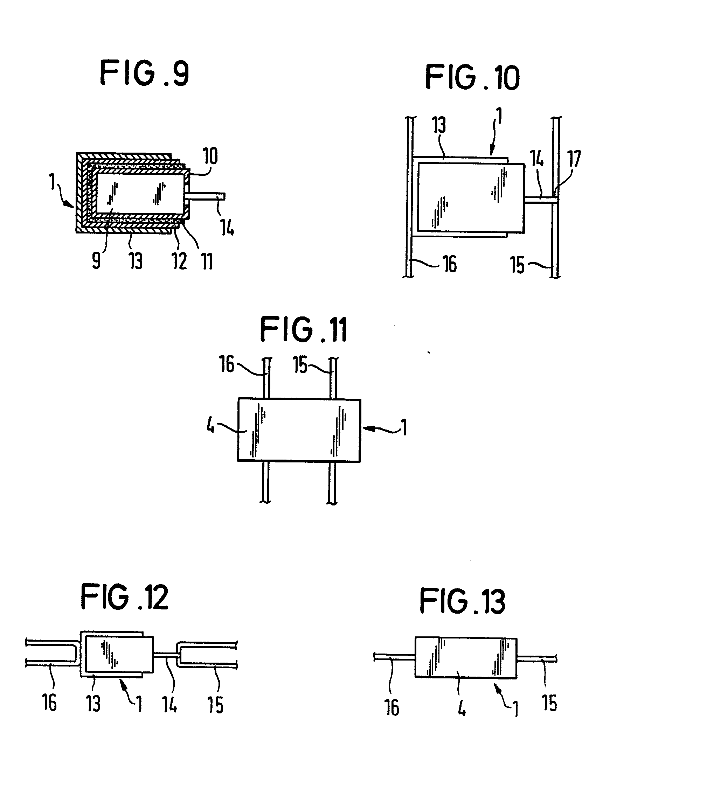

Fig. 9 zeigt den Grundaufbau eines Tantal-Kondensatorkörpers 1, bestehend aus einer Tantalanode 9 mit elektrolytisch erzeugter Oxydschicht als Dielektrikum, einer Gegenelektrode 10 aus einem Halbleiter, z.B. aus $MnO_2$, einer Graphitschicht 11, sowie Schichten 12, 13 aus Silber, Lötzinn oder leitendem Gießharz, wobei die Außenschicht 13 den Anodenboden bildet.

Das positive Anschlußelement 14 besteht aus einem in die Tantalanode 9 eingesinterten Tantaldraht.

Nach Fig. 10 ist mit dem positiven Anschlußelement 14 ein Runddraht 15 im rechten Winkel verschweißt, wobei die Länge dieses Runddrahtes 15 so gewählt ist, daß bezüglich des Tantalkörpers 1 ein beidseitiger Überstand entsteht.

Mit dem Anodenboden 13 ist als negativen Anschluß ein Runddraht 16 verlötet. Die beiden Runddrähte 15, 16 liegen bevorzugt in einer zur Längsachse des Tantalkörpers 1 parallelen Ebene.

Eine Schweißstelle 17 zwischen dem Anschlußelement 14 und dem Runddraht 15 besitzt einen deutlichen Abstand zum Tantalkörper 1. Dieser Abstand entspricht zumindest der halben Breite des Tantalkörpers.

Fig. 11 zeigt die Anordnung gemäß Fig. 10 nach erfolgter Aufbringung der Umhüllung 4. Diese Umhüllung kann durch Umpressen, Umgießen und dergleichen angebracht werden, und sie besitzt bevorzugt quaderförmige Gestalt. Die innerhalb der Umhüllung gelegenen Abschnitte der Runddrähte werden durch die Umhüllung in ihrer Lage eindeutig positioniert.

In Fig. 12 ist eine Variante der möglichen Kontaktierung dargestellt. Die positiven und negativen Runddrähte 15, 16, die mit dem Anschlußelement 14 verschweißt und mit dem Anodenboden 13 verlötet werden, besitzen dabei U-förmige Gestalt, wobei die Kontaktierung am schmalen Mittelschenkel erfolgt.

Während bei der Ausführungsvariante nach Fig. 10 die Anschlußdrähte gleicher Polarität um 180° gegeneinander versetzt sind, ergibt sich bei der Anordnung nach Fig. 12 ein Nebeneinanderliegen der Anschlußdrähte gleicher Polarität.

Fig. 5 zeigt eine Seitenansicht der Anordnung nach Fig. 12 nach Anbringung der Umhüllung 11.

Die in ihrem Aufbau fertigen Kondensatoren nach den Fig. 11 und 13 mit jeweils vier Anschlüssen, zwei Kathoden- und zwei Anodenanschlußdrähten, werden zum Einsatz als Chip-Kondensatoren zur Oberflächenmontage auf Substraten bevorzugt in der anhand der Fig. 6 und 7 erläuterten Weise weitergebildet, d.h. es werden die entsprechenden Flachdrahtabschnitte gebildet und diese Flachdrahtabschnitte in den ebenfalls erläuterten Weisen abgewinkelt. Es ergeben sich dabei wiederum die bereits erläuterten Vorteile.

Die beschriebenen Kondensatoren ermöglichen eine äußerst wirtschaftliche Fertigung, erbringen eine exakte Maßhaltigkeit und sind bestens für die automatische Bestückung geeignet, wobei das Zusammenspiel von Runddrahtabschnitten und Flachdrahtabschnitten sich fertigungsmäßig günstig auswirkt und vor allem hinsichtlich der beim Verlöten auftretenden Wärmebeanspruchung bedingt durch die Ausbildung von Wärmebarrieren zu einer Steigerung der Funktionssicherheit führt.

Patentansprüche:

1. Kondensator, insbesondere zur Oberflächenmontage durch Reflow- oder Schwallbadlötung, bestehend aus einem mit einer Umhüllung versehenen Kondensatorkörper mit einander gegenüberliegend in Form von Doppelanschlüssen aus der Umhüllung austretenden Anschlußelementen, dadurch g e k e n n z e i c h n e t , daß die Anschlußelemente (3; 15, 16) als Runddrähte ausgebildet sind, daß die über die Umhüllung (4) vorstehenden Runddrahtabschnitte zu Flachdrahtabschnitten (5) gepreßt sind, und daß jeder flachgepreßte Drahtabschnitt (5) zumindest eine im wesentlichen rechtwinklige Abknickung (6, 7) aufweist.

2. Kondensator nach Anspruch 1, dadurch g e k e n n z e i c h n e t , daß die Runddrähte (3; 15, 16) unmittelbar anschließend an die Austrittsstelle aus der Umhüllung (4) flachgepreßt und um 90° abgebogen sind.

3. Kondensator nach Anspruch 1 oder 2, dadurch g e k e n n z e i c h n e t , daß die Austrittsstellen der Anschlußdrähte (3; 15, 16) gleicher Polarität nebeneinander angeordnet oder um 180° gegeneinander versetzt sind.

4. Kondensator nach Anspruch 1, 2 oder 3, dadurch g e k e n n z e i c h n e t , daß die Umhüllung (4) quaderförmig ausgebildet ist, und daß die freien Enden der Anschlußdrähte maximal um 0,5 mm über die Umhüllung (4) vorstehen.

5. Kondensator nach Anspruch 4, dadurch g e k e n n z e i c h n e t , daß die Flachdrahtabschnitte (5) einerseits an der Austrittsstelle aus der Umhüllung (4) zur quaderförmigen Umhüllung (4) hin und andererseits im Bereich ihrer freien Enden zum Kondensatorkörper hin oder von diesem weg um 90° gebogen sind.

6. Kondensator nach Anspruch 1, dadurch g e k e n n z e i c h n e t , daß mit jedem stirnseitigen Anschlußbereich des Kondensatorkörpers der kurze Mittelschenkel eines U-förmig gebogenen Anschlußdrahtes (3; 15, 16) verbunden ist.

7. Kondensator nach einem der vorhergehenden Ansprüche, dadurch g e k e n n z e i c h n e t , daß als Kondensatorkörper ein aus Metall- und Dielektrikumsfolien oder aus metallisierten Folien, insbesondere in Schichtbauweise aufgebauter Körper verwendet ist.

8. Kondensator nach einem der Ansprüche 1 bis 6, dadurch g e k e n n z e i c h n e t , daß als Kondensatorkörper eine mit einem ersten Anschlußelement versehene Tantal-Anode mit einer als Dielektrikum wirkenden Oxydschicht, einer Halbleiter-Gegenelektrode und sich daran anschließenden, mit einem zweiten Anschlußelement verbundenen Kontaktierungsschichten sowie einer Umhüllung verwendet ist, wobei das erste Anschlußelement (14) innerhalb der Umhüllung (4) mit einem als Doppelanschluß aus der Umhüllung (4) austretenden Runddraht (15) verbunden ist und das zweite Anschlußelement aus einem ebenfalls als Doppelanschluß aus der Umhüllung (4) austretendem Runddraht (16) besteht.

9. Kondensator nach Anspruch 8, dadurch g e k e n n z e i c h n e t , daß der das zweite, negative Anschlußelement bildende Runddraht (16) in der gleichen Ebene wie die positiven Anschlußelemente (14, 15) gelegen und mit dem verzinnten Anodenboden (13) verlötet ist.

10. Kondensator nach einem der vorhergehenden Ansprüche, dadurch g e k e n n z e i c h n e t , daß die Anschluß-

drähte (15, 16) aus Material mit geringer Wärmeleitfähigkeit, insbesondere aus verzinktem Nickel, Neusilber oder Stahl bestehen.

1/2

**FIG.1**

**FIG.2**

**FIG.3**

**FIG.4**

**FIG.5**

**FIG.6**

**FIG.7**

**FIG.8**

# FIG.9

# FIG.10

# FIG.11

# FIG.12

# FIG.13